(19)

Europäisches
Patentamt

European
Patent Office

Office européen
des brevets

(11) **EP 4 664 101 A1**

(12) **EUROPEAN PATENT APPLICATION**
published in accordance with Art. 153(4) EPC

(43) Date of publication:
**17.12.2025 Bulletin 2025/51**

(21) Application number: **24829711.1**

(22) Date of filing: **05.01.2024**

(51) International Patent Classification (IPC):
**G01N 23/04** (2018.01)    **G06T 7/00** (2017.01)

(52) Cooperative Patent Classification (CPC):
Y02E 60/10

(86) International application number:
**PCT/CN2024/070902**

(87) International publication number:
**WO 2025/001048 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.06.2023   CN 202310797714**

(71) Applicant: **Contemporary Amperex Technology
Co., Limited
Ningde, Fujian 352100 (CN)**

(72) Inventor: **ZHANG, Fenglin
Ningde, Fujian 352100 (CN)**

(74) Representative: **Kraus & Lederer PartGmbB
Thomas-Wimmer-Ring 15
80539 München (DE)**

(54) **TEST APPARATUS FOR TABS OF BATTERY CELL, AND BATTERY CELL PRODUCTION
DEVICE**

(57)    A detection apparatus for a tab (501) of a battery cell (500) and a production device for the battery cell (500) are provided, belonging to the field of battery technology. The detection apparatus includes an X-ray source (100), a flat panel detector (200), a carrying platform (300), and a controller (400). The flat panel detector (200) is opposite an emission port of the X-ray source (100), the carrying platform (300) is located between the X-ray source (100) and the flat panel detector (200), and the controller (400) is electrically connected and/or communicatively connected to the flat panel detector (200). The controller (400) is configured to acquire a detection image of the tab (501) of the battery cell (500). The detection image is a detection image of the tab (501) acquired by the flat panel detector (200) based on received rays, where the rays are emitted by the X-ray source (100), pass through the tab (501) of the battery cell (500) placed on the carrying platform (300), and are then projected onto the flat panel detector (200). The detection apparatus determines defect information of the tab (501) based on the detection image. The detection apparatus can achieve comprehensive detection of the tab (501).

FIG. 1

EP 4 664 101 A1

## Description

## CROSS-REFERENCE TO RELATED APPLICATIONS

This application claims the priority of the Chinese Patent Application No. 202310797714.9, filed on June 30, 2023 and entitled "DETECTION APPARATUS FOR TAB OF BATTERY CELL AND PRODUCTION DEVICE FOR BATTERY CELL", which is incorporated herein by reference in its entirety.

## TECHNICAL FIELD

This application relates to the field of battery technology, in particular, to a detection apparatus for a tab of a battery cell and a production device for a battery cell.

## BACKGROUND

Energy conservation and emission reduction are key to the sustainable development of the automotive industry. Electric vehicles, due to their advantages of energy conservation and environmental friendliness, have become an important component of the sustainable development of the automotive industry. For electric vehicles, battery cell technology is a critical factor in connection with their development.

Tabs are metal conductors that lead out positive and negative electrodes from a battery cell. During the production process of battery cells, process errors may cause defects such as folding or breakage of the tabs, which affect the reliability of the battery cells. In related technologies, it is impossible to detect the tabs of battery cells, making it impossible to recognize tab defects, thereby affecting the reliability of the battery cells.

## SUMMARY

This application aims to at least solve one of the technical problems existing in the background art. To this end, an objective of this application is to provide a detection apparatus for a tab of a battery cell and a production device for a battery cell, to detect a tab of a battery cell.

According to a first aspect, an embodiment of this application provides a detection apparatus for a tab of a battery cell, including: an X-ray source; a flat panel detector, opposite an emission port of the X-ray source; a carrying platform, located between the X-ray source and the flat panel detector; and a controller electrically connected and/or communicatively connected to the flat panel detector; where the controller is configured to: acquire a detection image of the tab of the battery cell, the detection image being a detection image of the tab acquired by the flat panel detector based on received rays, where the rays are emitted by the X-ray source, pass through the tab of the battery cell placed on the carrying platform, and are then projected onto the flat panel detector; and determine defect information of the tab based on the detection image.

In the technical solution of this embodiment of this application, the tab of the battery cell can be detected through the X-ray source, the flat panel detector, and the carrying platform, and the detection image of the tab can be analyzed by the controller to obtain defect information of the tab, thereby completing the detection of the tab. The detection apparatus provided by this embodiment of this application can achieve detection of the tab, and the cooperation of the X-ray source and the flat panel detector provides high coverage for detecting process defects in the tab of the battery cell, enabling observation of defects that cannot be reliably detected by other testing methods, thus achieving comprehensive detection of the tab.

In some embodiments, the controller is further electrically connected and/or communicatively connected to the X-ray source, and the controller is further electrically connected and/or communicatively connected to the carrying platform. The tab includes a first tab and a second tab, and the first tab and the second tab are arranged along a first direction. The acquiring a detection image of the tab of the battery cell includes configuring the controller to: control the carrying platform to move, such that the first tab is located between the X-ray source and the flat panel detector; control the X-ray source to emit rays passing through the first tab and projected onto the flat panel detector; determine a first detection image of the first tab based on the rays received by the flat panel detector; control the carrying platform to move along the first direction, such that the second tab is located between the X-ray source and the flat panel detector; control the X-ray source to emit rays passing through the second tab and projected onto the flat panel detector; determine a second detection image of the second tab based on the rays received by the flat panel detector; and determine the detection image of the tab based on the first detection image and the second detection image. The two tabs (the first tab and the second tab) of the battery cell are separately detected, so that less information needs to be processed for each detection, realizing faster detection; additionally, a distance from the X-ray source to the boundary of the tab is smaller during the two detections, which can reduce the impact of edge distortion on detection results to some extent.

In some embodiments, the determining a first detection image of the first tab based on the rays received by the flat panel detector includes configuring the controller to: acquire multiple original images including the first tab based on the rays received by the flat panel detector; and process the multiple original images to obtain the first detection image of the first tab. If only one original image is acquired, any error in that image may cause an error in the subsequent processed first detection image, affecting detection accuracy. In these embodiments of this application, acquiring multiple original images and processing the multiple original images ensure that even if one original image contains an error, the other original images remain correct, reducing the impact of errors on the detection results.

In some embodiments, the processing the multiple original images to obtain the first detection image of the first tab includes configuring the controller to: perform noise reduction processing on the multiple original images to obtain a first image; capture a region including the first tab from the first image to obtain a second image; and perform image enhancement processing on the second image to obtain the first detection image of the first tab. Through the above processing steps, the first tab in the first detection image becomes clearer, and a defect region is more prominent, making it easier to recognize defects in the first tab.

In some embodiments, the controller stores a dimension of the first tab, and the capturing a region including the first tab from the first image to obtain a second image includes configuring the controller to: recognize a position of the first tab in the first image based on grayscale values in the first image; and capture a region including the first tab from the first image based on the position of the first tab and the dimension of the first tab to obtain the second image. Capturing a region including the first tab based on the position and dimension of the first tab enables the second image to include the first tab and also prevents, to some extent, the second image from including too many other regions due to an excessively large size, so as not to affect defect detection of the first tab.

In some embodiments, the controller stores a defect detection model, and the determining defect information of the tab based on the detection image includes configuring the controller to: input the detection image into the defect detection model to obtain the defect information of the tab outputted by the defect detection model. The defect detection model stores multiple defect types, and after the detection image is inputted into the defect detection model, the defect information of the tab in the detection image can be quickly recognized based on the stored defect types.

In some embodiments, a training process of the defect detection model includes: acquiring a sample detection image including a tab of a sample battery cell photographed under irradiation of the X-ray source; marking true defect information in the sample detection image; simultaneously inputting the sample detection image into the defect detection model to obtain predicted defect information of the sample battery cell outputted by the defect detection model; calculating a loss value based on the true defect information and the predicted defect information; and adjusting parameters of the defect detection model based on the loss value. Before detection, to-be-detected defective samples of various sizes and types can be first defined according to detection requirements to form a sample battery cell, with true defect information in the sample battery cell being marked. The sample battery cell is then detected, and the predicted defect information of the sample battery cell outputted by the defect detection model is compared with the true defect information to continuously improve the parameters of the defect detection model, making defect detection more accurate.

In some embodiments, the defect information includes tab folding and/or tab breakage. Tab folding and tab breakage are both defects of the tab, and setting tab folding and/or tab breakage as defect information enables detection of tab defects.

In some embodiments, the X-ray source includes an integrated X-ray source. An integrated X-ray source has a low repair rate, high stability, small size, and simple post-maintenance, and setting the X-ray source as an integrated X-ray source improves the reliability of the detection apparatus.

In some embodiments, a distance L1 between the X-ray source and the carrying platform and a distance L2 between the flat panel detector and the carrying platform satisfy: L2 > L1. This ensures that a magnification during detection is greater than 2, making it easier to observe tab defects in the detection image.

In some embodiments, the distance L1 between the X-ray source and the carrying platform and the distance L2 between the flat panel detector and the carrying platform satisfy: $2 < \frac{L1+L2}{L1} \leq 8$. Based on the principle of similar triangles, a magnification N of the detection apparatus is equal to $\frac{L1+L2}{L1}$. An excessively small magnification N results in a failure in effectively achieving a magnification effect; and an excessively large magnification N may lead to fuzziness of the detection image and affect the detection effect. Limiting the magnification to the above range not only achieves a magnification effect for the detection image, but also avoids impacts on the detection effect to some extent.

In some embodiments, the distance L1 between the X-ray source and the carrying platform satisfies: 30 mm ≤ L1 ≤ 50 mm. If the distance L1 between the X-ray source and the carrying platform is too small, a radiation surface formed by X-rays on a carrying surface of the carrying platform becomes smaller, potentially leaving some regions of the tab of the battery cell unirradiated by the X-rays, and thus leading to missed detection. If the distance L1 between the X-ray source and the carrying platform is too large, an overall size of the detection apparatus is large. Limiting the distance L1 between the X-ray source and the carrying platform to 30 mm ≤ L1 ≤ 50 mm not only avoids missed detection to some extent but also avoids an excessively large size of the detection apparatus to some extent.

In some embodiments, the distance L2 between the flat panel detector and the carrying platform satisfies: 50 mm ≤ L2 ≤ 200 mm. If the distance L2 between the flat panel detector and the carrying platform is too small, the magnification is too small, failing to effectively magnify the detection image. If the distance L2 between the flat panel detector and the carrying platform is too large, the overall size of the detection apparatus is large. Limiting the distance L2 between the flat panel detector and the carrying platform to 50 mm $\leq$ L2 $\leq$ 200 mm can not only increase the magnification to some extent but also avoid an excessively large size of the detection apparatus to some extent.

In some embodiments, a voltage U of the X-ray source satisfies: 70 kV $\leq$ U $\leq$ 90 kV, and/or a current I of the X-ray source satisfies: 80 $\mu$A $\leq$ I $\leq$ 120 $\mu$A. This ensures that the X-rays emitted by the X-ray source can penetrate the tab for detection, without causing overexposure which may affect detection accuracy.

In some embodiments, a frame rate F of the flat panel detector satisfies: 5 fps $\leq$ F $\leq$ 20 fps. This enables the flat panel detector to acquire multiple original images at one time, reducing the impact of random errors on the detection results, and also avoiding acquisition of too many original images at one time to some extent while such acquisition prolongs subsequent image processing time.

According to a second aspect, an embodiment of this application provides a production device for a battery cell, including the detection apparatus according to any one of the above embodiments.

The above description is only an overview of the technical solutions of this application. To provide a clearer understanding of the technical means of this application and enable implementation in accordance with the content of the specification, and to make the above and other objectives, features, and advantages of this application more apparent and understandable, specific embodiments of this application are provided below.

**BRIEF DESCRIPTION OF DRAWINGS**

In the drawings, unless otherwise specified, identical reference signs throughout multiple drawings denote identical or similar components or elements. These drawings may not necessarily be drawn to scale. It should be understood that these drawings illustrate only some embodiments disclosed in this application and should not be construed as limiting the scope of this application. To describe the technical solutions in the embodiments of this application more clearly, the following briefly describes the drawings required for describing the embodiments of this application. Apparently, the drawings in the following descriptions show merely some embodiments of this application, and persons of ordinary skill in the art may derive other drawings from these drawings without creative efforts.

FIG. 1 is a schematic structural diagram of a detection apparatus according to some embodiments of this application;
FIG. 2 is a block diagram of a detection apparatus according to some embodiments of this application;
FIG. 3 is a control flowchart of a controller according to some embodiments of this application;
FIG. 4 is a control flowchart of a controller according to some embodiments of this application;
FIG. 5 is a control flowchart of a controller according to some embodiments of this application;
FIG. 6 is a control flowchart of a controller according to some embodiments of this application;
FIG. 7 is a control flowchart of a controller according to some embodiments of this application;
FIG. 8 is a control flowchart of a controller according to some embodiments of this application; and
FIG. 9 is a front view of a detection apparatus according to some embodiments of this application.

Description of reference signs:
100. X-ray source; 200. flat panel detector; 300. carrying platform; 400. controller; 500. battery cell; 501. tab; 5011. first tab; and 5012. second tab.

**DESCRIPTION OF EMBODIMENTS**

The embodiments of the technical solutions of this application will be described in detail below with reference to the drawings. The following embodiments are merely intended to clearly illustrate the technical solutions of this application and are therefore used as only examples, which do not limit the protection scope of this application.

Unless otherwise defined, all technical and scientific terms used herein have the same meanings as commonly understood by those skilled in the technical field of this application; the terms used herein are for the purpose of describing specific embodiments only and are not intended to limit this application; the terms "include", "comprise", and any variations thereof in the specification, claims, and descriptions of the drawings of this application are intended to cover non-exclusive inclusions.

In the description of the embodiments of this application, technical terms such as "first" and "second" are used only to distinguish between different objects and should not be understood as indicating or implying relative importance or implicitly indicating the number, specific order, or primary-secondary relationship of the technical features indicated. In the description of the embodiments of this application, "multiple" means two or more, unless otherwise explicitly and specifically limited.

Reference to "embodiment" in this specification means that specific features, structures, or characteristics described with reference to the embodiment may be included in at least one embodiment of this application. The appearance of this phrase in various places in the specification does not necessarily refer to the same embodiment, nor is it an independent or alternative embodiment mutually exclusive with other embodiments. Persons skilled in the art explicitly and implicitly understand that the embodiments described herein may be combined with other embodiments.

In the description of the embodiments of this application, the term "and/or" is merely an associative relationship describing associated objects, indicating that three relationships may exist. For example, A and/or B may indicate the following three cases: presence of only A, presence of both A and B, and presence of only B. Additionally, the character "/" herein generally indicates an "or" relationship between the contextually associated objects.

In the description of the embodiments of this application, the term "multiple" refers to two or more (including two), similarly, "multiple groups" refers to two or more groups (including two groups), and "multiple pieces" refers to two or more pieces (including two pieces).

In the description of the embodiments of this application, the orientations or positional relationships indicated by technical terms such as "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", and "circumferential" are based on the orientations or positional relationships shown in the drawings. These terms are used for ease and brevity of description of the embodiments of this application and do not indicate or imply that the mentioned apparatuses or components must have specific orientations or be constructed or manipulated in specific orientations, and therefore should not be construed as limiting the embodiments of this application.

In the description of the embodiments of this application, unless otherwise explicitly specified and limited, technical terms such as "mounting", "connection", "join", and "fastening" should be understood in a broad sense. For example, it may refer to a fixed connection, a detachable connection, or an integral formation; it may refer to a mechanical connection or an electrical connection; it may refer to a direct connection or an indirect connection through an intermediate medium; and it may refer to an internal communication between two elements or interaction between two elements. Persons of ordinary skill in the art can understand the specific meanings of the above terms in the embodiments of this application based on specific circumstances.

Currently, from the perspective of market development trends, the application of traction batteries is becoming increasingly widespread. Traction batteries are not only used in energy storage systems such as hydropower, thermal power, wind power, and solar power plants but are also widely applied in electric vehicles such as electric bicycles, electric motorcycles, and electric cars, as well as in military equipment, aerospace, and other fields. As the application fields of traction batteries continue to expand, the market demand for them is also continuously increasing.

During the production and use of a battery cell, defects may occur in the battery cell. For example, during the production process of the battery cell, defects such as tab folding or tab breakage may occur, and the defective battery cell needs to be removed to avoid affecting the reliability of the battery cell to some extent. However, these defects cannot be observed from the exterior of the battery cell, so the interior of the battery cell needs to be detected. In related technologies, it is impossible to detect the tab of battery cells, affecting the reliability of the battery cell.

An embodiment of this application provides a detection apparatus for a tab of a battery cell, including: an X-ray source, a flat panel detector, a carrying platform, and a controller, where the flat panel detector is opposite an emission port of the X-ray source, the carrying platform is located between the X-ray source and the flat panel detector, and the controller is electrically connected and/or communicatively connected to the flat panel detector. The controller is configured to: acquire a detection image of the tab of the battery cell, the detection image being a detection image of the tab acquired by the flat panel detector based on received rays, where the rays are emitted by the X-ray source, pass through the tab of the battery cell placed on the carrying platform, and are then projected onto the flat panel detector; and determine defect information of the tab based on the detection image. The tab of the battery cell is detected through the X-ray source and the flat panel detector to obtain a detection image, and then defects in the tab of the battery cell are recognized through the detection image, thereby enabling detection of the tab of the battery cell.

The detection apparatus for a tab of a battery cell disclosed in this embodiment of this application can be used to detect newly manufactured battery cells, determine whether the battery cells are qualified based on detection results, and then remove unqualified battery cells, thereby improving the reliability of the battery cells to some extent. In addition, the detection apparatus can also be used to detect battery cells that have been used for a period, to detect the reliability of the battery cells.

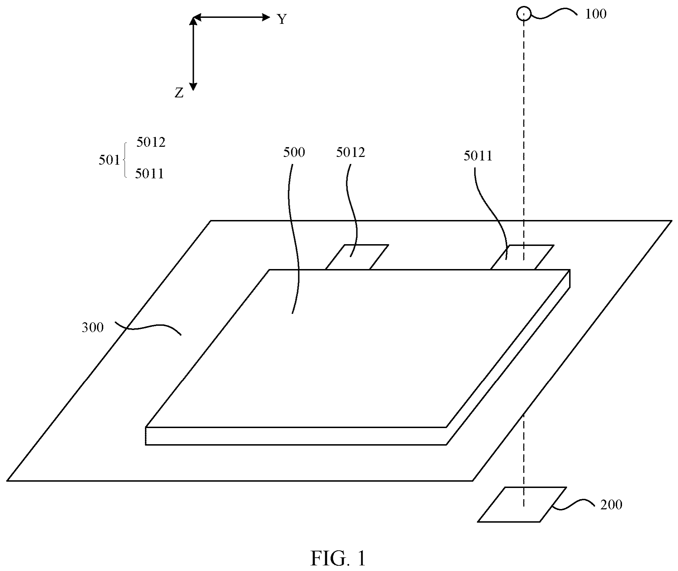

An embodiment of this application provides a detection apparatus for a tab of a battery cell. FIG. 1 is a schematic structural diagram of a detection apparatus according to some embodiments of this application. Referring to FIG. 1, the detection apparatus includes an X-ray source 100, a flat panel detector 200, and a carrying platform 300. The flat panel detector 200 is opposite an emission port of the X-ray source 100, and the carrying platform 300 is located between the X-ray source 100 and the flat panel detector 200. A battery cell 500 is also shown in the figure.

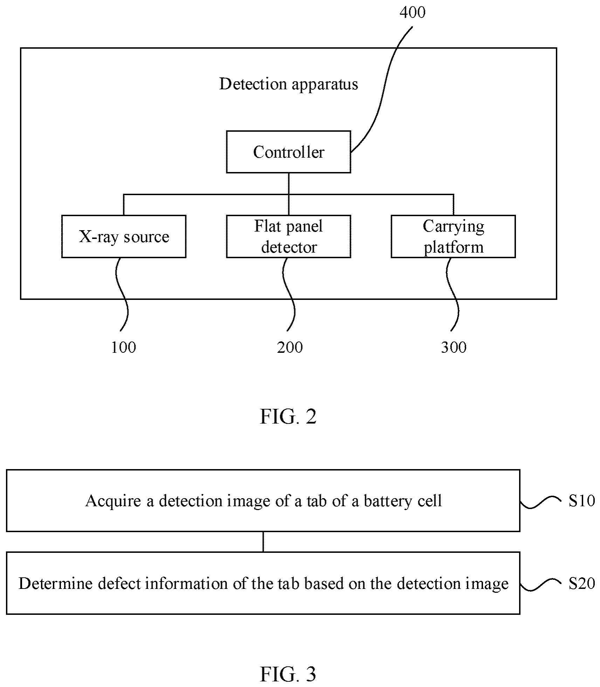

FIG. 2 is a block diagram of a detection apparatus according to some embodiments of this application. Referring to FIG. 2, the detection apparatus further includes a controller 400, where the controller 400 is electrically connected and/or communicatively connected to the flat panel detector 200.

FIG. 3 is a control flowchart of a controller according to some embodiments of this application. Referring to FIG. 3, the controller 400 is configured to perform the following steps.

Step S10: Acquire a detection image of a tab of a battery cell.

The detection image is a detection image of the tab 501 acquired by the flat panel detector 200 based on received rays, where the rays are emitted by the X-ray source 100, pass through the tab 501 of the battery cell 500 placed on the carrying platform 300, and are then projected onto the flat panel detector 200.

Step S20: Determine defect information of the tab based on the detection image.

In these embodiments of this application, the battery cell 500 may be a laminated battery cell or a wound battery cell. The shape of the battery cell is similar to a cuboid, and the battery cell 500 has two oppositely disposed large surfaces and four side faces connecting the two large surfaces. In one implementation of this application, one of the large surfaces of the battery cell 500 is placed on a carrying surface of the carrying platform 300, such that a thickness direction Z of the battery cell 500 is perpendicular to the carrying surface of the carrying platform 300.

For example, when the detection apparatus is used to detect the battery cell 500, the battery cell 500 can be placed on the carrying platform 300 to ensure that the large surface of the battery cell 500 is attached to the carrying surface of the carrying platform 300, meaning the thickness direction Z of the battery cell 500 is perpendicular to the carrying surface. Then, the X-ray source 100 is used to project X-rays onto the tab 501 of the battery cell 500, the rays are projected onto the flat panel detector 200, and the flat panel detector 200 acquires a detection image of the tab 501 based on the received rays.

The rays emitted by the X-ray source 100 have good penetrability, enabling detection of thick battery cells. Additionally, X-ray detection technology provides high coverage for detecting process defects in tabs of battery cells, enabling observation of defects that cannot be reliably detected by other testing methods.

The flat panel detector 200 can convert the rays emitted by the X-ray source 100 into electrical signals. The flat panel detector 200 can increase an image readout speed and reduce exposure time, thereby improving efficiency.

The X-rays emitted by the X-ray source 100 are penetrative, and materials having different thicknesses attenuate the rays to varying degrees, resulting in different amounts of rays detected by the flat panel detector 200. Inside the flat panel detector 200, there is a layer of radiation-sensitive luminescent material that emits visible light signals under ray excitation. The visible light signals are transmitted to a photoelectric converter to form electrical signals, which are then outputted as digital signals through an internal electrical signal transmission circuit, and the digital signals are characterized on an image to form an image with light and dark contrast. The X-rays are attenuated to some extent after penetrating through a to-be-detected object. When more X-rays penetrate the object, a photosensitive material emits more light signals, so that this region in a final image is brighter. Conversely, when fewer X-rays penetrate the object, this region in the image is darker.

In these embodiments of this application, the tab 501 of the battery cell 500 can be positioned between the flat panel detector 200 and the X-ray source 100 by controlling the movement of the flat panel detector 200 and the X-ray source 100, controlling the movement of the carrying platform 300, or controlling the movement of the flat panel detector 200 and the X-ray source 100 as well as the carrying platform 300. Thus, the rays emitted by the X-ray source 100 during detection can pass through the tab 501 and be projected onto the flat panel detector 200.

In these embodiments of this application, the X-ray source 100 may be installed on a mobile platform, the mobile platform is capable of moving in three mutually perpendicular directions, and the movement of the X-ray source 100 is achieved by controlling the movement of the mobile platform.

Similarly, the flat panel detector 200 and the carrying platform 300 may be installed in the same manner as the X-ray source 100 to achieve the movement of the panel detector 200 and the carrying platform 300.

In other implementations of this application, the carrying platform 300 may be a conveyor belt, or the carrying platform 300 may be a circular guide rail, making the carrying platform 300 movable.

In these embodiments of this application, the controller 400 is electrically connected and/or communicatively connected to the flat panel detector 200, enabling the controller 400 to receive the detection image of the tab 501.

In these embodiments of this application, a load-bearing capacity of the carrying platform 300 is greater than a weight of the battery cell 500 placed thereon.

In some embodiments of this application, the controller 400 is electrically connected to the flat panel detector 200. In some other embodiments of this application, the controller 400 is communicatively connected to the flat panel detector 200; or the controller 400 is communicatively and electrically connected to the flat panel detector 200.

In these embodiments of this application, the defect information of the tab 501 includes morphological defects such as folding and breakage of the tab 501.

In these embodiments of this application, the defect information of the tab 501 can be used to indicate whether the battery cell 500 is qualified.

In these embodiments of this application, if the tab 501 is folded or broken, grayscale changes appear in the detection image, and the defect information of the tab 501 can be determined based on the grayscale changes in the detection image.

The controller 400 may include a memory and a processor, where the memory is configured to store instructions, and the processor is configured to read the instructions and execute commands based on the instructions.

In these embodiments of this application, the flat panel detector 200 can be calibrated before detection begins to reduce errors in the detection image. For example, before formal operation, the flat panel detector 200 needs to be calibrated. Before calibration, there should be no impurities on the emission port of the X-ray source 100 or on the surface of the flat panel detector 200, as well as no obstructions between the X-ray source 100 and the flat panel detector 200. The rays need to fully cover a receiving surface of the flat panel detector 200, and grayscale values of an image produced by the detection apparatus at that time can be adjusted to calibration grayscale values.

The detection apparatus provided by these embodiments of this application can be used to detect a tab of a battery cell through the X-ray source 100, the flat panel detector 200, and the carrying platform 300, and the detection image of the tab 501 is analyzed through the controller 400 to obtain defect information of the tab 501, thereby completing the detection of the tab 501. The detection apparatus provided by these embodiments of this application can achieve detection of the tab 501, and the cooperation of the X-ray source 100 and the flat panel detector 200 provides high coverage for detecting process defects in the tab 501 of the battery cell, enabling observation of defects that cannot be reliably detected by other testing methods, thus achieving comprehensive detection of the tab 501.

According to some embodiments of this application, referring to FIG. 2, the controller 400 is further electrically connected and/or communicatively connected to the X-ray source 100, and the controller 400 is further electrically connected and/or communicatively connected to the carrying platform 300. Referring to FIG. 1, the tab 501 includes a first tab 5011 and a second tab 5012, where the first tab 5011 and the second tab 5012 are arranged along a first direction Y.

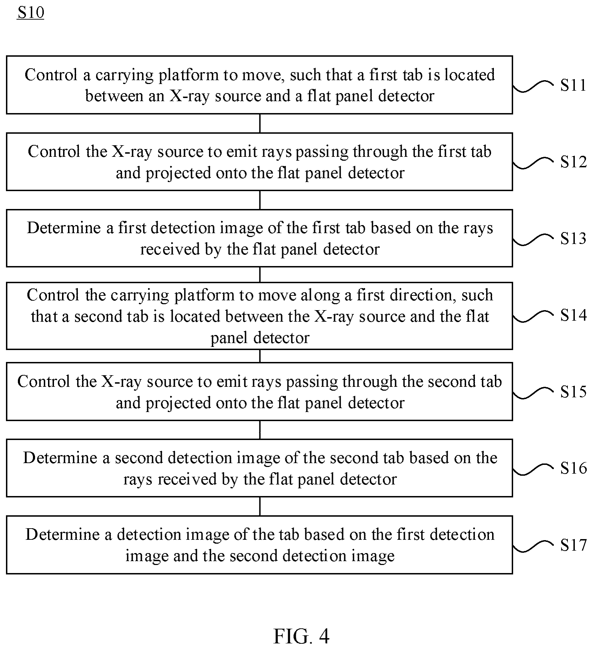

FIG. 4 is a control flowchart of a controller according to some embodiments of this application. Referring to FIG. 4, step S10 includes configuring the controller 400 to perform the following steps.

Step S11: Control the carrying platform to move, such that the first tab is located between the X-ray source and the flat panel detector.

Step S12: Control the X-ray source to emit rays passing through the first tab and projected onto the flat panel detector.

Step S13: Determine a first detection image of the first tab based on the rays received by the flat panel detector.

Step S14: Control the carrying platform to move along the first direction, such that the second tab is located between the X-ray source and the flat panel detector.

Step S15: Control the X-ray source to emit rays passing through the second tab and projected onto the flat panel detector.

Step S16: Determine a second detection image of the second tab based on the rays received by the flat panel detector.

Step S17: Determine the detection image of the tab based on the first detection image and the second detection image.

In these embodiments of this application, the movement of the battery cell 500 is controlled by controlling the movement of the carrying platform 300. The battery cell 500 is relatively small in size, and controlling the movement of the battery cell 500 is more convenient than controlling the movement of the X-ray source 100 and the flat panel detector 200.

In these embodiments of this application, the carrying platform 300 is movable, and a movement trajectory of the carrying platform 300 passes between the X-ray source 100 and the flat panel detector 200. After one battery cell is detected, the carrying platform 300 can be moved to allow the detection apparatus to detect another battery cell, achieving continuous detection of battery cells, thereby improving detection efficiency.

In these embodiments of this application, a position of the battery cell 500 can be adjusted by moving a position of the carrying platform 300, such that the tab 501 of the battery cell 500 can be located between the X-ray source 100 and the flat panel detector 200.

In these embodiments of this application, during detection of the first tab 5011, the position can be adjusted to make sure that a line connecting the center of the X-ray source 100 and the center of a surface of the first tab 5011 facing the X-ray source 100 is perpendicular to a surface of the first tab 5011 facing the X-ray source 100, and then detection of the first tab 5011 is completed. During detection of the second tab 5012, the carrying platform can be controlled to move along the first direction Y, with a movement distance being equal to a distance between the center of the surface of the first tab 5011 facing the X-ray source 100 and the center of a surface of the second tab 5012 facing the X-ray source 100. This ensures that during detection of the second tab 5012, a line connecting the center of the X-ray source 100 and the center of the surface of the second tab 5012 facing the X-ray source 100 is perpendicular to the surface of the second tab 5012 facing the X-ray source 100, thereby reducing the impact of edge distortion.

In these embodiments of this application, the two tabs (the first tab 5011 and the second tab 5012) of the battery cell 500 are separately detected, so that less information needs to be processed for each detection, realizing faster detection; additionally, a distance from the X-ray source 100 to the boundary of the tab is smaller during the two detections, which can reduce the impact of edge distortion on detection results to some extent.

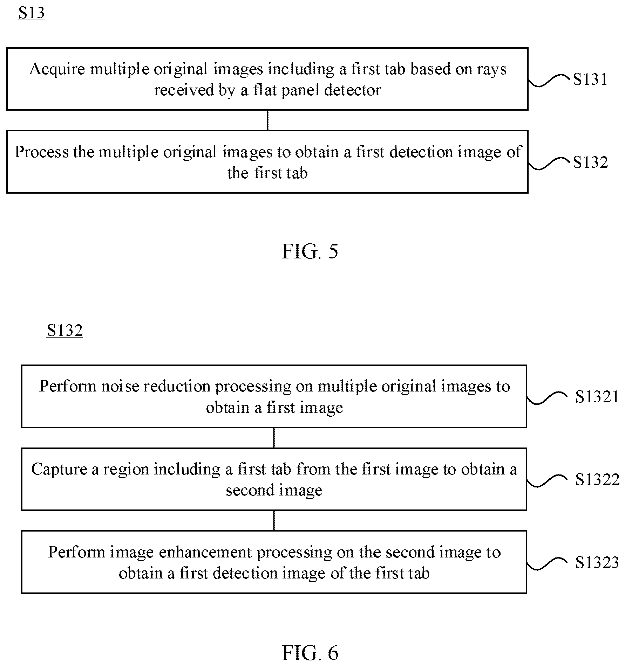

According to some embodiments of this application, FIG. 5 is a control flowchart of a controller according to some embodiments of this application. Referring to FIG. 5, step S13 includes configuring the controller 400 to perform the following steps.

Step S131: Acquire multiple original images including the first tab based on the rays received by the flat panel detector.

Step S132: Process the multiple original images to obtain the first detection image of the first tab.

In these embodiments of this application, the original images are unprocessed images. In this case, the first tab 5011 in the images is not clear enough. Processing the multiple original images makes the first tab 5011 in the images clearer, making it easier to recognize defects in the first tab 5011.

In these embodiments of this application, if only one original image is acquired, any error in that image may cause an error in the subsequent processed first detection image, affecting detection accuracy. In these embodiments of this application, acquiring multiple original images and processing the multiple original images ensure that even if one original image contains an error, the other original images remain correct, reducing the impact of errors on the detection results.

In these embodiments of this application, if the battery cell 500, the X-ray source 100, and the flat panel detector 200 are all fixed during acquisition, the differences between the multiple original images are minimal.

In these embodiments of this application, the number of to-be-acquired original images of the first tab can be set according to requirements. For example, 10 original images may be acquired.

According to some embodiments of this application, FIG. 6 is a control flowchart of a controller according to some embodiments of this application. Referring to FIG. 6, step S132 includes configuring the controller 400 to perform the following steps.

Step S1321: Perform noise reduction processing on the multiple original images to obtain a first image.

Step S1322: Capture a region including the first tab from the first image to obtain a second image.

Step S1323: Perform image enhancement processing on the second image to obtain the first detection image of the first tab.

In these embodiments of this application, irrelevant information can be removed from the multiple original images through noise reduction processing, reducing noise in the original images and increasing a signal-to-noise ratio of the original images.

In these embodiments of this application, after the first image is obtained, the first image can be saved, and the multiple original images can be deleted to free up memory.

In the original images, not only the first tab 5011 but also other regions are included. In these embodiments of this application, capturing the region including the first tab 5011 can reduce subsequent computations and reduce the impact of errors in other regions on the defect detection of the first tab 5011.

In these embodiments of this application, the first detection image of the first tab 5011 is obtained by processing the multiple original images through the above steps. The flat panel detector 200 can also be controlled to acquire multiple original images including the second tab 5012 and process the multiple original images by using a similar method, to obtain a second detection image of the second tab 5012.

In these embodiments of this application, the performing image enhancement processing on the second image includes contrast enhancement and/or filtering, which can enhance the contrast of various parts in the second image, highlight defect regions in the tab, and facilitate algorithmic recognition. That the performing image enhancement processing on the second image includes contrast enhancement and/or filtering may represent that the second image may be subjected to contrast enhancement only, the second image may be subjected to filtering only, or the second image may be subjected to both contrast enhancement and filtering.

In these embodiments of this application, through the above processing steps, the first tab 5011 in the first detection image becomes clearer, and defect regions are more prominent, making it easier to recognize defects in the first tab 5011.

In these embodiments of this application, the detection image and corresponding defect information can be uploaded to a cloud system, facilitating viewing and data tracing.

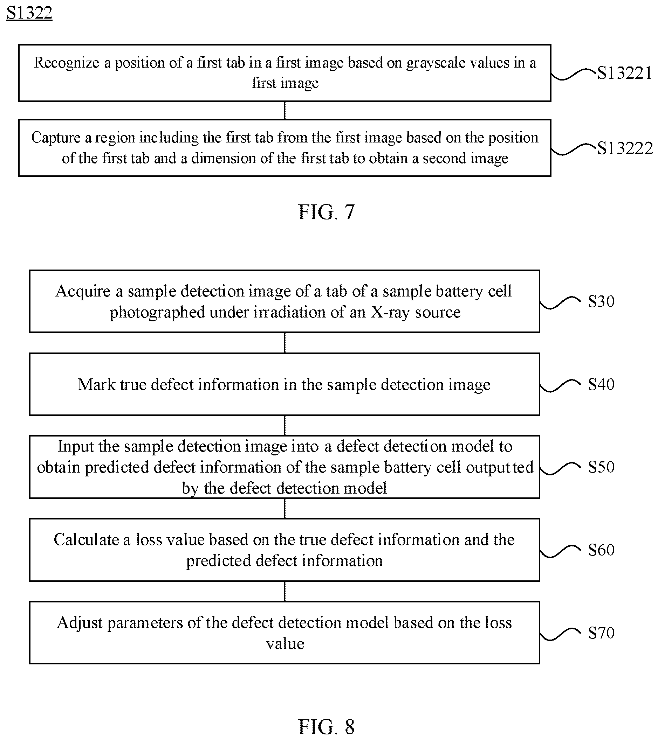

According to some embodiments of this application, the controller 400 stores a dimension of the first tab 5011. FIG. 7 is a control flowchart of a controller according to some embodiments of this application. Referring to FIG. 7, step S1322 includes configuring the controller 400 to perform the following steps.

Step S13221: Recognize a position of the first tab in the first image based on grayscale values in the first image.

Step S13222: Capture a region including the first tab from the first image based on the position of the first tab and a dimension of the first tab to obtain a second image.

Materials of different thicknesses attenuate X-rays to varying degrees, and therefore exhibit different grayscale values in the first image. An outline of the first tab 5011 can be recognized through the grayscale values, thereby determining the position of the first tab 5011 in the first image.

The controller 400 stores the dimension of the first tab 5011 and allows for a certain dimensional tolerance for capturing, making the captured region slightly larger than the first tab, to prevent some regions of the first tab from being captured, so as not to affect detection accuracy.

For example, a difference between an area of the captured region and an area of the first tab in the first image, divided by the area of the first tab in the first image, is greater than or equal to 5% and less than or equal to 20%. This not only provides a certain dimensional tolerance for capturing but also prevents an excessively large captured region to some extent, so as not to affect subsequent computation.

In these embodiments of this application, capturing the region including the first tab based on the position and dimension of the first tab enables the second image to include the first tab 501 and also prevents, to some extent, the second image from including too many other regions due to an excessively large size, so as not to affect defect detection of the first tab 5011.

According to some embodiments of this application, the controller 400 stores a defect detection model, and step S20 includes configuring the controller 400 to perform the following step.

Step S21: Input the detection image into the defect detection model to obtain defect information of the tab outputted by the defect detection model.

In these embodiments of this application, the defect detection model stores multiple defect types, and after the detection image is inputted into the defect detection model, the defect information of the tab in the detection image can be quickly recognized based on the multiple defect types stored in the defect detection model.

In these embodiments of this application, the multiple defect types stored in the defect detection model include various information such as defect types, defect sizes, and defect positions.

According to some embodiments of this application, FIG. 8 is a control flowchart of a controller according to some embodiments of this application. Referring to FIG. 8, the training process of the defect detection model includes the following steps.

Step S30: Acquire a sample detection image including a tab of a sample battery cell photographed under irradiation of the X-ray source.

Step S40: Mark true defect information in the sample detection image.

Step S50: Simultaneously input the sample detection image into a defect detection model to obtain predicted defect information of the sample battery cell outputted by the defect detection model.

Step S60: Calculate a loss value based on the true defect information and the predicted defect information.

Step S70: Adjust parameters of the defect detection model based on the loss value.

In these embodiments of this application, the parameters of the defect detection model can be improved through the sample battery cell, and the detection image of the tab obtained from each detection can also be used to improve the parameters of the defect detection model.

For example, after detection is completed, defects in the detection image can be marked, so as to be convenient to observe by workers and also convenient to check by workers. If errors occur, the parameters of the defect detection model can be adjusted based on the errors to form a more accurate defect detection model.

For example, the defect detection model can continuously learn grayscale features of the detection image through a convolutional neural network and adjust internal parameters, so that the defect detection model is improved.

In these embodiments of this application, before detection, to-be-detected defect of various sizes and types can be defined according to detection requirements to form a sample battery cell, with true defect information in the sample battery cell being marked. The sample battery cell is then detected, and the predicted defect information of the sample battery cell outputted by the defect detection model is compared with the true defect information to continuously improve the parameters of the defect detection model, making defect detection more accurate.

According to some embodiments of this application, the defect information includes tab folding and/or tab breakage.

Tab folding and tab breakage are both defects of the tab, and setting tab folding and/or tab breakage as defect information enables detection of tab defects.

According to some embodiments of this application, the X-ray source 100 includes an integrated X-ray source.

An integrated X-ray source has a low repair rate, high stability, small size, and simple post-maintenance, and setting the X-ray source 100 as an integrated X-ray source improves the reliability of the detection apparatus.

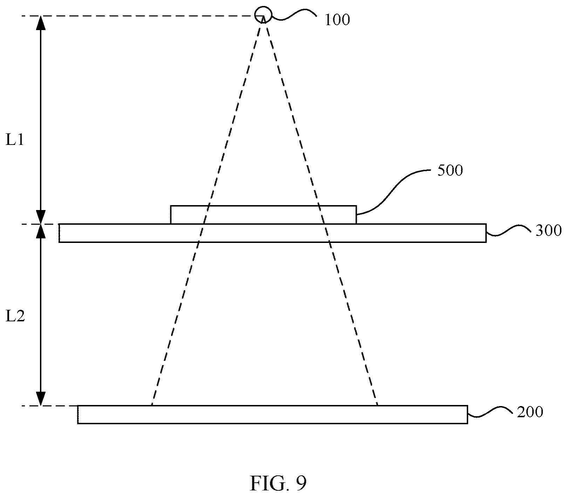

According to some embodiments of this application, FIG. 9 is a front view of a detection apparatus according to some embodiments of this application. Referring to FIG. 9, a distance between the X-ray source 100 and the carrying platform 300 is L1, and a distance between the flat panel detector 200 and the carrying platform 300 is L2, where L2 and L1 satisfy: L2 > L1.

In these embodiments of this application, during detection, it can be understood that the distance L1 between the X-ray source 100 and the carrying platform 300 is a distance between the X-ray source 100 and the battery cell 500, where a thickness of the battery cell 500 is relatively small compared to L1, so the thickness of the battery cell 500 can be ignored. The distance L2 between the flat panel detector 200 and the carrying platform 300 is a distance between the flat panel detector 200 and the battery cell 500, where the distance L2 between the flat panel detector 200 and the carrying platform 300 is a distance between a surface of the carrying platform 300 facing the X-ray source 100 and the flat panel detector 200.

In these embodiments of this application, the contour of the rays emitted by the X-ray source 100 is conical. Based on the principle of similar triangles, a magnification N during detection is equal to $\frac{L1+L2}{L1}$.

In these embodiments of this application, it is defined that L2 > L1, so that the magnification during detection is greater than 2, making it easier to observe tab defects in the detection image.

According to some embodiments of this application, the distance L1 between the X-ray source 100 and the carrying platform 300 and the distance L2 between the flat panel detector 200 and the carrying platform 300 satisfy: $2 < \frac{L1+L2}{L1} \le 8$ .

In these embodiments of this application, an excessively small magnification N results in a failure in effectively achieving a magnification effect; and an excessively large magnification N may lead to fuzziness of the detection image and affect the detection effect. Limiting the magnification to the above range not only achieves a magnification effect for the detection image, but also avoids impacts on the detection effect to some extent.

According to some embodiments of this application, the distance L1 between the X-ray source 100 and the carrying platform 300 satisfies: 30 mm (millimeters) ≤ L1 ≤ 50 mm (millimeters).

In these embodiments of this application, the contour of the rays emitted by the X-ray source 100 is conical. A smaller distance L1 between the X-ray source 100 and the carrying platform 300 results in a smaller radiation surface formed by the X-rays on the carrying surface of the carrying platform 300.

In these embodiments of this application, if the distance L1 between the X-ray source 100 and the carrying platform 300 is too small, the radiation surface formed by the X-rays on the carrying surface of the carrying platform 300 becomes smaller, potentially leaving some regions of the tab 501 of the battery cell 500 unirradiated by the X-rays, and thus leading to missed detection. If the distance L1 between the X-ray source 100 and the carrying platform 300 is too large, an overall size of the detection apparatus is large. Limiting the distance L1 between the X-ray source 100 and the carrying platform 300 to 30 mm ≤ L1 ≤ 50 mm not only avoids missed detection to some extent but also avoids an excessively large size of the detection apparatus to some extent.

In these embodiments of this application, the detection apparatus can be used to detect battery cells 500 of different sizes by adjusting the distance L1 between the X-ray source 100 and the carrying platform 300.

According to some embodiments of this application, the distance L2 between the flat panel detector 200 and the carrying platform 300 satisfies: 50 mm ≤ L2 ≤ 200 mm.

In these embodiments of this application, if the distance L2 between the flat panel detector 200 and the carrying platform 300 is too small, the magnification is too small, failing to effectively magnify the detection image. If the distance L2 between the flat panel detector 200 and the carrying platform 300 is too large, the overall size of the detection apparatus is large. Limiting the distance L2 between the flat panel detector 200 and the carrying platform 300 to 50 mm ≤ L2 ≤ 200 mm not only increases the magnification to some extent but also avoids an excessively large size of the detection apparatus to some extent.

According to some embodiments of this application, a voltage U of the X-ray source 100 satisfies: 70 kV (kilovolts) ≤ U ≤ 90 kV (kilovolts), and/or a current I of the X-ray source 100 satisfies: 80 μA (microamps) ≤ I ≤ 120 μA (microamps).

The energy of the X-rays emitted by the X-ray source 100 is related to the voltage U of the X-ray source 100, where a higher voltage U results in greater energy of the X-rays emitted by the X-ray source 100. The intensity of the X-rays emitted by the X-ray source 100 is related to the current I of the X-ray source 100, where a larger current I results in a higher intensity of the X-rays emitted by the X-ray source 100.

The detection apparatus provided by these embodiments of this application is used to detect the tab 501 of the battery cell 500, where the thickness of the tab 501 is less than a thickness of a body of the battery cell 500. During detection of the tab 501, the voltage U of the X-ray source 100 and the current I of the X-ray source 100 need to ensure that the X-rays can penetrate the tab 501.

In these embodiments of this application, the voltage U of the X-ray source 100 may satisfy: 70 kV ≤ U ≤ 90 kV; or the current I of the X-ray source 100 may satisfy: 80 μA ≤ I ≤ 120 μA. Alternatively, the voltage U of the X-ray source 100 satisfies: 70 kV ≤ U ≤ 90 kV, and the current I of the X-ray source 100 satisfies: 80 μA ≤ I ≤ 120 μA.

In these embodiments of this application, setting the voltage U of the X-ray source 100 to 70 kV ≤ U ≤ 90 kV and/or setting the current I of the X-ray source 100 to 80 μA ≤ I ≤ 120 μA ensures that the X-rays emitted by the X-ray source 100 can penetrate the tab 501 for detection without causing overexposure which affects detection accuracy.

According to some embodiments of this application, a frame rate F of the flat panel detector 200 satisfies: 5 fps ≤ F ≤ 20 fps, where fps stands for Frames Per Second, that is, the number of frames transmitted per second. In these embodiments of this application, it can represent the number of original images acquired per second.

The frame rate F of the flat panel detector 200 is related to the number of original images acquired by the flat panel detector 200 at one time. The impact of random errors on the detection results is reduced by acquiring multiple original images.

In these embodiments of this application, setting the frame rate F of the flat panel detector 200 to 5 fps ≤ F ≤ 20 fps allows the flat panel detector 200 to acquire multiple original images at one time, reducing the impact of random errors on the detection results, and also avoiding acquisition of too many original images at one time to some extent while such acquisition prolongs subsequent image processing time.

An embodiment of this application provides a production device for a battery cell, including the detection apparatus according to any one of the above embodiments.

The detection apparatus provided by the embodiments of this application can be used to detect manufactured battery cells and remove battery cells whose tabs are unqualified in defect detection, thereby improving the safety of battery cells.

The detection apparatus provided by the embodiments of this application can be placed after a battery cell winding or laminating device. Electrode plates are wound or laminated to form a battery cell, the battery cell is transferred on a logistics line, and the battery cell is placed onto the carrying platform by a mechanical arm, enabling detection of the tab of the battery cell without disassembly or additional processing.

In this embodiment of this application, the production device for a battery cell may include multiple detection apparatuses. The multiple detection apparatuses are arranged along the first direction Y. The multiple detection apparatuses can be used to simultaneously detect multiple battery cells 500, improving detection efficiency to some extent.

An embodiment of this application provides a detection apparatus for a tab of a battery cell, where the detection apparatus includes an X-ray source 100, a flat panel detector 200, a carrying platform 300, and a controller 400. The flat panel detector 200 is opposite an emission port of the X-ray source 100. The X-ray source 100, the flat panel detector 200, and the carrying platform 300 are all movable, and a movement trajectory of the carrying platform 300 passes between the X-ray source 100 and the flat panel detector 200. The controller 400 is electrically connected and/or communicatively connected to the X-ray source 100, the controller 400 is electrically connected and/or communicatively connected to the flat panel detector 200, and the controller 400 is electrically connected and/or communicatively connected to the carrying platform 300. The tab 501 of the battery cell 500 includes a first tab 5011 and a second tab 5012. The controller 400 is configured to perform the following steps.

Step S81: Control the carrying platform to move, such that the first tab is located between the X-ray source and the flat panel detector.

Step S82: Control the X-ray source to emit rays passing through the first tab and projected onto the flat panel detector.

Step S83: Determine a first detection image of the first tab based on the rays received by the flat panel detector.

Step S84: Control the carrying platform to move along the first direction, such that the second tab is located between the X-ray source and the flat panel detector.

Step S85: Control the X-ray source to emit rays passing through the second tab and projected onto the flat panel detector.

Step S86: Determine a second detection image of the second tab based on the rays received by the flat panel detector.

Step S87: Determine the detection image of the tab based on the first detection image and the second detection image.

Step S88: Input the detection image into a defect detection model to obtain defect information of the tab outputted by the defect detection model.

Step S89: Determine a quality detection result of the tab of the battery cell based on the defect information.

The detection apparatus provided by this embodiment of this application can achieve full-automatic detection of a tab of a battery cell with high detection speed and accuracy.

In conclusion, it should be noted that the above embodiments are only used to illustrate the technical solutions of this application rather than to limit them. Although this application has been described in detail with reference to the foregoing embodiments, persons of ordinary skill in the art should understand that they can still modify the technical solutions recorded in the foregoing embodiments or make equivalent replacements for some or all of the technical features. Such modifications or replacements do not cause the essence of the corresponding technical solutions to depart from the scope of the technical solutions of the embodiments of this application and should be included within the scope of the claims and specification of this application. In particular, as long as there is no structural conflict, the technical features mentioned in the various embodiments can be combined in any manner. This application is not limited to the specific embodiments disclosed in this specification but includes all technical solutions falling within the scope of the claims.

**Claims**

1. A detection apparatus for a tab of a battery cell, comprising:

   an X-ray source;
   a flat panel detector, opposite an emission port of the X-ray source;
   a carrying platform, located between the X-ray source and the flat panel detector; and
   a controller electrically connected and/or communicatively connected to the flat panel detector;
   wherein the controller is configured to:

   acquire a detection image of the tab of the battery cell, the detection image being a detection image of the tab acquired by the flat panel detector based on received rays, wherein the rays are emitted by the X-ray source, pass through the tab of the battery cell placed on the carrying platform, and are then projected onto the flat panel detector; and

determine defect information of the tab based on the detection image.

2. The detection apparatus according to claim 1, wherein the controller is further electrically connected and/or communicatively connected to the X-ray source, the controller is further electrically connected and/or communicatively connected to the carrying platform, the tab comprises a first tab and a second tab, and the first tab and the second tab are arranged along a first direction;

wherein the acquiring a detection image of the tab of the battery cell comprises configuring the controller to:

control the carrying platform to move, such that the first tab is located between the X-ray source and the flat panel detector;

control the X-ray source to emit rays passing through the first tab and projected onto the flat panel detector;

determine a first detection image of the first tab based on the rays received by the flat panel detector;

control the carrying platform to move along the first direction, such that the second tab is located between the X-ray source and the flat panel detector;

control the X-ray source to emit rays passing through the second tab and projected onto the flat panel detector;

determine a second detection image of the second tab based on the rays received by the flat panel detector; and

determine the detection image of the tab based on the first detection image and the second detection image.

3. The detection apparatus according to claim 2, wherein the determining a first detection image of the first tab based on the rays received by the flat panel detector comprises configuring the controller to:

acquire multiple original images comprising the first tab based on the rays received by the flat panel detector; and

process the multiple original images to obtain the first detection image of the first tab.

4. The detection apparatus according to claim 3, wherein the processing the multiple original images to obtain the first detection image of the first tab comprises configuring the controller to:

perform noise reduction processing on the multiple original images to obtain a first image; capture a region comprising the first tab from the first image to obtain a second image; and perform image enhancement processing on the second image to obtain the first detection image of the first tab.

5. The detection apparatus according to claim 4, wherein the controller stores a dimension of the first tab, and the capturing a region comprising the first tab from the first image to obtain a second image comprises configuring the controller to:

recognize a position of the first tab in the first image based on grayscale values in the first image; and

capture a region comprising the first tab from the first image based on the position of the first tab and a dimension of the first tab to obtain the second image.

6. The detection apparatus according to any one of claims 1 to 5, wherein the controller stores a defect detection model, and the determining defect information of the tab based on the detection image comprises configuring the controller to:
input the detection image into the defect detection model to obtain the defect information of the tab outputted by the defect detection model.

7. The detection apparatus according to claim 6, wherein a training process of the defect detection model comprises:

acquiring a sample detection image comprising a tab of a sample battery cell photographed under irradiation of the X-ray source;

marking true defect information in the sample detection image;

simultaneously inputting the sample detection image into the defect detection model to obtain predicted defect information of the sample battery cell outputted by the defect detection model;

calculating a loss value based on the true defect information and the predicted defect information; and

adjusting parameters of the defect detection model based on the loss value.

8. The detection apparatus according to any one of claims 1 to 7, wherein the defect information comprises tab folding and/or tab breakage.

9. The detection apparatus according to any one of claims 1 to 8, wherein the X-ray source comprises an integrated X-ray source.

10. The detection apparatus according to any one of claims 1 to 9, wherein a distance L1 between the X-ray source and the carrying platform and a distance L2 between the flat panel detector and the carrying platform satisfy: L2 > L1.

11. The detection apparatus according to any one of claims 1 to 10, wherein the distance L1 between the X-ray source and the carrying platform and the distance L2 between the flat panel detector and the carrying platform satisfy: $2 < \frac{L1+L2}{L1} \leq 8$.

12. The detection apparatus according to any one of claims 1 to 11, wherein the distance L1 between the X-ray source and the carrying platform satisfies: 30 mm $\leq$ L1 $\leq$ 50 mm.

13. The detection apparatus according to any one of claims 1 to 12, wherein the distance L2 between the flat panel detector and the carrying platform satisfies: 50 mm $\leq$ L2 $\leq$ 200 mm.

14. The detection apparatus according to any one of claims 1 to 13, wherein a voltage U of the X-ray source satisfies: 70 kV $\leq$ U $\leq$ 90 kV, and/or a current I of the X-ray source satisfies: 80 $\mu$A $\leq$ I $\leq$ 120 $\mu$A.

15. The detection apparatus according to any one of claims 1 to 14, wherein a frame rate F of the flat panel detector satisfies: 5 fps $\leq$ F $\leq$ 20 fps.

16. A production device for a battery cell, comprising the detection apparatus according to any one of claims 1 to 15.

FIG. 1

400

Detection apparatus

Controller

| X-ray source | Flat panel detector | Carrying platform |

100                     200                     300

FIG. 2

| Acquire a detection image of a tab of a battery cell | S10 |

| Determine defect information of the tab based on the detection image | S20 |

FIG. 3

<u>S10</u>

| | |
|---|---|
| Control a carrying platform to move, such that a first tab is located between an X-ray source and a flat panel detector | S11 |
| Control the X-ray source to emit rays passing through the first tab and projected onto the flat panel detector | S12 |
| Determine a first detection image of the first tab based on the rays received by the flat panel detector | S13 |
| Control the carrying platform to move along a first direction, such that a second tab is located between the X-ray source and the flat panel detector | S14 |
| Control the X-ray source to emit rays passing through the second tab and projected onto the flat panel detector | S15 |
| Determine a second detection image of the second tab based on the rays received by the flat panel detector | S16 |
| Determine a detection image of the tab based on the first detection image and the second detection image | S17 |

FIG. 4

S13

| Acquire multiple original images including a first tab based on rays received by a flat panel detector | S131 |

| Process the multiple original images to obtain a first detection image of the first tab | S132 |

FIG. 5

S132

| Perform noise reduction processing on multiple original images to obtain a first image | S1321 |

| Capture a region including a first tab from the first image to obtain a second image | S1322 |

| Perform image enhancement processing on the second image to obtain a first detection image of the first tab | S1323 |

FIG. 6

S1322

| |
|---|
| Recognize a position of a first tab in a first image based on grayscale values in a first image |

S13221

| |
|---|
| Capture a region including the first tab from the first image based on the position of the first tab and a dimension of the first tab to obtain a second image |

S13222

FIG. 7

| |
|---|
| Acquire a sample detection image of a tab of a sample battery cell photographed under irradiation of an X-ray source |

S30

| |
|---|
| Mark true defect information in the sample detection image |

S40

| |
|---|
| Input the sample detection image into a defect detection model to obtain predicted defect information of the sample battery cell outputted by the defect detection model |

S50

| |
|---|
| Calculate a loss value based on the true defect information and the predicted defect information |

S60

| |
|---|
| Adjust parameters of the defect detection model based on the loss value |

S70

FIG. 8

FIG. 9

## INTERNATIONAL SEARCH REPORT

International application No.

**PCT/CN2024/070902**

### A. CLASSIFICATION OF SUBJECT MATTER

G01N 23/04(2018.01)i; G06T 7/00(2017.01)i

According to International Patent Classification (IPC) or to both national classification and IPC

### B. FIELDS SEARCHED

Minimum documentation searched (classification system followed by classification symbols)

IPC: G01N 23/-; G06T 7/-

Documentation searched other than minimum documentation to the extent that such documents are included in the fields searched

Electronic data base consulted during the international search (name of data base and, where practicable, search terms used)

CNTXT, ENTXT, DWPI, CNKI: 电池, 极耳, 缺陷, 检测, X射线, X光, 探测器, 载物台, 图像, 模型, 控制; battery, tab?, lug?, defect?, detect+, X-ray, sensor?, carrier, image?, model, control+

### C. DOCUMENTS CONSIDERED TO BE RELEVANT

| Category* | Citation of document, with indication, where appropriate, of the relevant passages | Relevant to claim No. |
|---|---|---|
| Y | CN 113618356 A (SHENZHEN YARUI INTELLIGENT TECHNOLOGY CO., LTD.) 09 November 2021 (2021-11-09) description, paragraphs [0002]-[0030] | 1-16 |
| Y | CN 116203051 A (UNICOMP TECHNOLOGY CO., LTD.) 02 June 2023 (2023-06-02) description, paragraphs [0002]-[0020] and [0051] | 1-16 |
| Y | CN 109142367 A (GUANGZHOU SUPERSONIC AUTOMATION TECHNOLOGY CO., LTD.) 04 January 2019 (2019-01-04) description, paragraphs [0001]-[0026] | 6-16 |
| A | CN 115205247 A (SHANGHAI SENSETIME INTELLIGENT TECHNOLOGY CO., LTD.) 18 October 2022 (2022-10-18) entire document | 1-16 |
| A | KR 20100122613 A (MEERE COMPANY INC.) 23 November 2010 (2010-11-23) entire document | 1-16 |
| A | KR 102236815 B1 (PARK, Young Ho) 06 April 2021 (2021-04-06) entire document | 1-16 |

☐ Further documents are listed in the continuation of Box C.    ☑ See patent family annex.

| * | Special categories of cited documents: | | |
|---|---|---|---|
| "A" | document defining the general state of the art which is not considered to be of particular relevance | "T" | later document published after the international filing date or priority date and not in conflict with the application but cited to understand the principle or theory underlying the invention |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 March 2024** | **20 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2024/070902** |

| Patent document cited in search report | | | Publication date (day/month/year) | Patent family member(s) | Publication date (day/month/year) |
| --- | --- | --- | --- | --- | --- |
| CN | 113618356 | A | 09 November 2021 | None | |
| CN | 116203051 | A | 02 June 2023 | None | |
| CN | 109142367 | A | 04 January 2019 | None | |
| CN | 115205247 | A | 18 October 2022 | None | |
| KR | 20100122613 | A | 23 November 2010 | None | |
| KR | 102236815 | B1 | 06 April 2021 | None | |

Form PCT/ISA/210 (patent family annex) (July 2022)

**EP 4 664 101 A1**

## REFERENCES CITED IN THE DESCRIPTION

**Patent documents cited in the description**

- CN 202310797714